# EUROPEAN PATENT APPLICATION

(11) **EP 1 936 396 A1**
(43) Date of publication of application: **25.06.2008**
(21) Application number: 06292044.2
(22) Date of filing: 22.12.2006
(51) Int. Cl.: G01R 31/3193

(54) **Integrated circuit with built-in test circuit**

(71) Applicant: NXP B.V., 5656 AG Eindhoven (NL)
(72) Inventor: The designation of the inventor has not yet been filed
(74) Representative: White, Andrew Gordon

(57) **Abstract**

An integrated circuit (11) comprises a functional circuit (10) and a built-in test circuit (12) for measuring timing properties of a signal under test from the functional circuit (10). The built in built-in test circuit (12) has a test signal input coupled to a signal line (100, 30, 32) in the functional circuit (10). A signal conditioning circuit (122) with inputs coupled to the test signal input and the clock signal input and a plurality of pairs of outputs, each for supplying signals derived from the clock signal and a signal under test from the test signal input, the signal conditioning circuit (122) being configured to apply respective, mutually different, relative delays between signals at the respective outputs. The built in built-in test circuit (12) has a plurality of counter circuits (126), each corresponding to a respective one of the outputs, and configured to count edges in the signal derived from the clock signal at the respective one of the outputs during a time interval derived from the signal under test signal at the respective one of the outputs. A tester apparatus (20) decides between accepting and rejecting the integrated circuit based on a sum of the counts.

## Description

### Field of the invention

The invention relates to an integrated circuit comprising a built in test circuit for testing the integrated circuit.

### Background

From EP 1043596 it is known to provide an integrated circuit with a built in test circuit for measuring duration of pulses in the integrated circuit. This circuit can be used in addition to more conventional test circuits that detect only static circuit properties. The test circuit described in this document uses a chain of delay circuits and a set of latches coupled to respective ones of the delay circuits. In operation a pulse under test is applied to an input of the chain of delay circuits and the latches are set if the start of the pulse reaches their corresponding delay circuits before the end of the pulse. Afterwards the content of the latches is read out for evaluation.

However, in this type of circuit tests can be performed only with limited accuracy.

### Summary

Among others, it is an object of the invention to provide for an integrated circuit with an alternative built in test circuit that can provide timing measurements with improved accuracy.

An integrated circuit according to claim 1 is provided. Herein a signal under test is derived from a signal line in the functional circuit of the integrated circuit. A built in test circuit in the integrated circuit comprises a signal conditioning circuit for imparting a plurality of different relative delays between the signal under test and a clock signal. The test circuit comprises a plurality of counter circuits, each corresponding to a respective one of the delays, and configured to count edges in the signal derived from the clock signal during a time interval derived from the signal under test signal with the respective one of the delays relative to each other. A test readout circuit is coupled to the plurality of counter circuits. In an embodiment the sum of the count results is used to decide on a result of the test. The test circuit in the integrated circuit may contain a circuit for computing the sum, but alternatively the sum may be computed outside the integrated circuit.

In an embodiment the clock signal is derived from an external clock signal supplied from outside the integrated circuit, for example from an external tester. By using delays defined in the built in test circuit accurate and reliable test results can be obtained without imposing strict requirements on the supply of the clock signal. In a further embodiment the clock signal is a special test clock signal supplied via an external terminal of the integrated circuit that is not used to supply a clock signal during normal operation.

In an embodiment there the relative delays are different integer multiples a basic delay period. In this way an accurate test result can be obtained. The basic delay may be a clock period of the operation test clock signal divided by a number N, wherein N is the number of counter circuits used to count clock pulses.

In an embodiment a circuit with an exclusive OR function is used to form the signal under test from signals at different signal lines in the functional circuit. The circuit with an exclusive OR function may be an exclusive OR gate, or an exclusive NOR gate or any other circuit with a similar function, that forms a pulse with a width dependent on a time interval between transitions in the signals from the functional circuit. The circuit with an exclusive OR function is provided especially for test purposes: its output is not coupled to the functional circuit to supply functional signals.

In an embodiment gate circuit are used to gate the clock signal under control of the signal under test and the result is applied as clock signal to the counter circuits. Alternatively, counter circuits may be used that have a disable input coupled to receive signals derived from the signal under test. The delays may be provided by plurality of delay circuits coupled between the clock signal input and the outputs.

### Brief description of the drawing

These and other objects and advantageous aspects will become apparent from a description of exemplary embodiments, using the following figures,
Figure 1 shows an integrated circuit
Figure 2 shows a test configuration
Figure 3 shows a built in test circuit

### Detailed description of exemplary embodiments

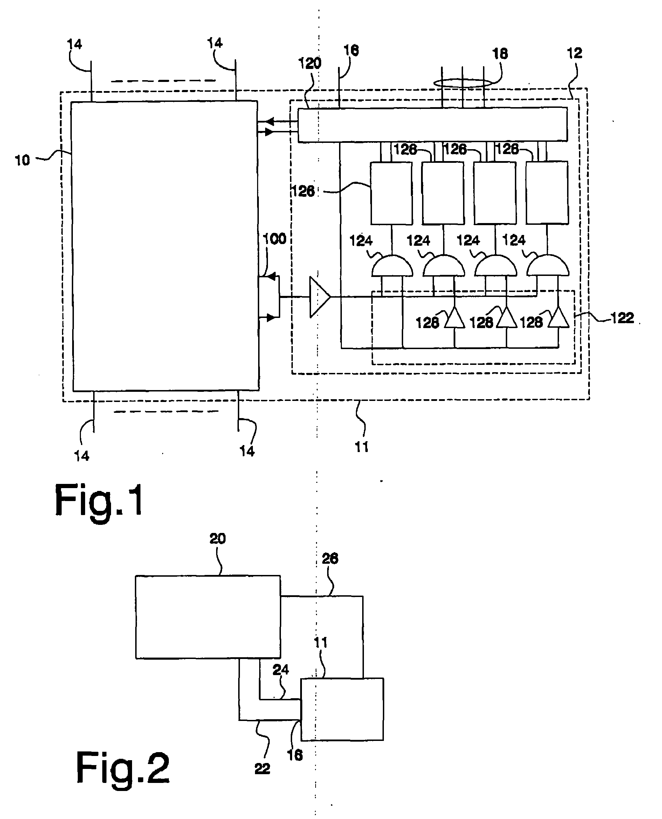

Figure 1 shows an integrated circuit 11, comprising a functional circuit 10 and a built-in test circuit 12. Functional circuit 10 has inputs and outputs coupled to external terminals 14 of the integrated circuit. Functional circuit 10 comprises a signal line 100 coupled to built in test circuit 12. Built in test circuit 12 comprises a test control circuit 120 with test control and/or data inputs outputs coupled to functional circuit 10.

Built in test circuit 12 further comprises a clock input coupled to an external clock terminal 16, control input/outputs coupled to external terminals 18, a signal conditioning circuit 122, a plurality of gate circuits 124, and a plurality of counters 126. In the figure signal conditioning circuit 122 comprises a plurality of delay circuits 128, constructed to pass signals with mutually different amounts of delay. Signal line 100 of functional circuit 10 is coupled to first inputs of gate circuits 124. Second inputs of gate circuits 124 are coupled to external clock terminal 16, via test control circuit 120 and respective ones of delay circuits 128. Outputs of gate circuits 124 are coupled to inputs of respective ones of counters 126. Outputs of counters 126 are coupled to test control circuit 120. Test control circuit has reset outputs coupled to counters 126.

Figure 2 shows a test configuration comprising a tester 20 and a sample of the integrated circuit 11 connected via a clock line 22 connected to clock terminal 16, one or more input lines 24 and one or more output lines.

In operation tester 20 supplies test control signals and/or test input signal to integrated circuit 11. Tester 20 also supplies clock pulses via clock line 22. The test comprises measurement of a pulse duration of a pulse generated on signal line 100. During this test, test control circuit 120 controls functional circuit 10 to generate the pulse on signal line 100. Test control circuit 120 passes the clock pulses to gate circuits 124 at least during a time interval in which the resulting pulse is expected to occur.

The pulse from signal line 100 determines an active time interval during which clock gate circuits 124 pass clock pulses to counters 126. The clock signals are passed to gate circuits 124 directly and via delay circuits 128. Gate circuits 124 pass the clock signals to counter inputs of counters 126 during the active time interval defined by the pulse from signal line 100.

After the active time interval test control circuit 120 reads out count results from counters 126 and sums these results. An adder (not shown) may be used for this purpose, or a suitably programmed data processor in test control circuit 120 may be used for this. In an embodiment test control circuit 120 compares the sum with one or more reference values and signals to tester 20 whether an error was detected based on the result of the comparison. An error signal may be generated when the sum exceeds a first reference value and/or when the sum exceeds a second reference value, the first and second reference value representing a maximum and minimum allowable pulse duration. The result of the comparison may be signalled as part of an overall pass/fail result. Alternatively it may be signalled separately from other test results. In another embodiment test control circuit may be configured to transmit the sum, or the individual counter results to tester 20, for a similar evaluation.

The use of a plurality of counters combined with delay circuits 128 in the built in test circuit 12 of the integrated circuit make it possible to use a tester 20 and test clock connections 22 that are incapable of supplying clock signals with sufficiently high frequency and/or phase accuracy to measure the duration of the pulses at signal line 100 with sufficient accuracy for test purposes.

Due the different delays of delay circuits 128 the relative phase of the clock signals with respect to the active time interval is different for different counters 126. When the duration of the active time interval is not an integer number of clock periods, this has the effect that the number of clock pulses passed to different counters 126 during the active time interval may vary by one clock pulse, as a function of the relative phase. In other words, the number of clock pulses is a function of the delay imparted to the pulse signal. This function is periodic as a function of the delay. If one considers this function over a range of delay values of at least one such period, the fraction of the delay values for which the function results in the highest count value is approximately proportional to the difference between the duration of the pulse and the nearest lower integer number of clock periods. Hence, by counting the clock pulses for different delays and averaging (summing) the result an estimate of the pulse duration can be obtained with an accuracy that is higher than can be obtained by one counter.

Preferably the different delays provided by delay circuits 128 substantially correspond to different integer multiples of a fraction of the clock period. Thus if N-1 delay circuits 128 are used, their delays are approximately k/N of the clock period, for integers k=1, 2,...N-1. However, such a choice of delay values is not essential. Averaging results in an improved measurement of pulse duration also when the delays are different integer multiples of any basic delay that differs sufficiently from an integer number of clock periods. The frequency of tester 20 can always be set to avoid the latter. Even if the delays are not integer multiples of a common basic delay, e.g. when they are randomly chosen, the average counter value may give an improved estimate of the pulse duration. It suffices that the delay values are distributed over a range wherein different count values result from different delays.

By providing for delay circuits 128 with mutually different delays in integrated circuit 11, the differences between the delays can be made independent of external factors, such as the connections to tester 20. Thus reliable testing is possible without a need for high quality high frequency connections. Although the circuit is suitable for external supply of clock pulses, as an alternative a more complicated test circuit may be used that generates the clock pulses internally.

In an embodiment test control circuit 120 applies control signals to functional circuit 10 during a test mode to cause the pulse to be generated. As an alternative tester 20 may be used to supply signals to functional circuit 10 to cause the pulse to be generate. Subsequently or simultaneously test control circuit 120 starts to enable the supply of clock signals to conditioning circuit. Thus specific pulses can be tested. Before this test control circuit 120 causes counters 126 to be reset. Alternatively tester 20, test control circuit 120 and/or functional circuit 10 may be configured to cause a plurality of the pulses to be generated without resetting counters 126 between these pulses. In this case the cumulative count results are summed and compared to one or more reference values. Thus the measurement accuracy can be increased.

Although a specific embodiment has been shown, it should be appreciated that other circuits may be used to realize the same effect. For example, instead of delay circuits for delaying the clock signals and a direct connection for the pulse, conditioning circuit 122 may use delay circuits for delaying the pulse from signal line 100, or a combination of both. Also, instead of different delay circuits 128 a chain of delay circuits may be used, which it tapped to supply signals to inputs of different gate circuits 124. Gate circuits 124 may be implemented as ANG gates, but any other type of gate circuit (e.g. NAND gates etc.) may be used.

Although a single connection between signal line 100 and conditioning circuit has been shown (e.g. via a buffer), it should be appreciated that alternatively a multiplexing circuit controlled by test control circuit 120 may be used coupled between a plurality of signal lines of functional circuit 10 and conditioning circuit 122. This allows testing of pulse duration at different signal lines.

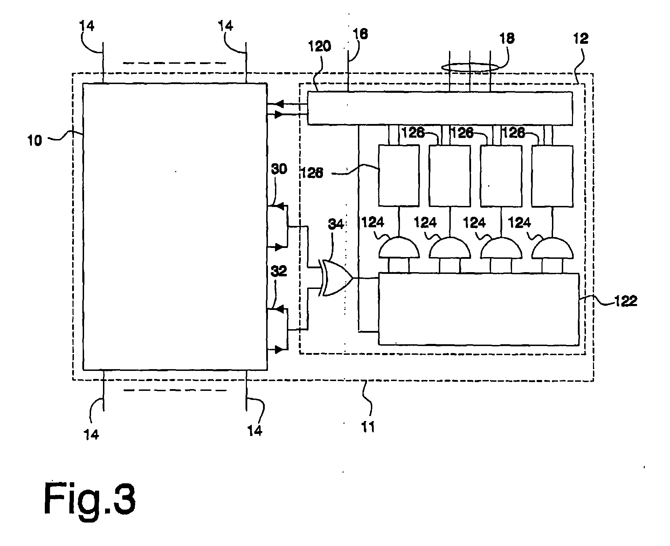

Figure 3 shows a test circuit wherein also mutual delays between different signals from functional circuit 10 can be tested. Herein an exclusive or circuit 34 with inputs coupled to signal lines 30, 32 in functional circuit 10 for different signals has an output coupled to the pulse duration testing circuit. A multiplexing circuit (not shown) may be used coupled between a plurality of signal lines of functional circuit 10 and the inputs of exclusive or circuit 34. This allows testing mutual delays duration at different signal lines.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. Any reference signs in the claims should not be construed as limiting the scope.

## Claims

1. An integrated circuit (11) comprising a functional circuit (10) and a built-in test circuit (12) for measuring timing properties of a signal under test from the functional circuit (10), wherein the built in built-in test circuit (12) comprises
- a test signal input coupled to a signal line (100, 30, 32) in the functional circuit (10);
- a clock signal input for a clock signal;
- a signal conditioning circuit (122) with inputs coupled to the test signal input and the clock signal input and a plurality of pairs of outputs, each for supplying signals derived from the clock signal and a signal under test from the test signal input, the signal conditioning circuit (122) being configured to apply respective, mutually different, relative delays between signals at the respective outputs;
- a plurality of counter circuits (126), each corresponding to a respective one of the outputs, and configured to count edges in the signal derived from the clock signal at the respective one of the outputs during a time interval derived from the signal under test signal at the respective one of the outputs;
- a test readout circuit (120) coupled to the plurality of counter circuits.

2. An integrated circuit according to claim 1, having an external clock input (16) coupled to the clock signal input for defining the clock signal.

3. An integrated circuit according to claim 1, wherein the respective, mutually different, relative delays applied by the signal conditioning circuit are different substantially integer multiples a basic delay period.

4. An integrated circuit according to claim 1, wherein the functional circuit (10) comprises a further signal line (32), the integrated circuit comprising a circuit (34) with an exclusive OR function with inputs coupled to the signal line (30) and the further signal line (32) and an output coupled only to the test signal input.

5. An integrated circuit ;according to claim 1, comprising a plurality of gate circuits (124), each coupled between a respective one of the outputs and a respective one of the inputs, and configured to gate the clock signal under control of the signal under test.

6. An integrated circuit according to claim 1, wherein the signal conditioning circuit (122) comprises direct connections from the test signal input to the outputs and a plurality of delay circuits (128) coupled between the clock signal input and the outputs.

7. A method of testing an integrated circuit (11) that comprises a functional circuit (10) and a built-in test circuit (12), the method comprising
- deriving a signal under test from a signal at a signal line (100, 30, 32) in the functional circuit (10);
- supplying a clock signal;
- using the test circuit (12) in the integrated circuit (11) to perform counts of edges in the clock signal in each of a plurality of partly overlapping time intervals, each time interval being:defined by the signal under test and a respective delay provided in the test circuit;
- reading out the results of the counts;
- automatically deciding between accepting and rejecting the integrated circuit based on a sum of the counts.

8. A method according to claim 7, wherein the clock signal is supplied by a tester (20) outside the integrated circuit (11).

9. A method according to claim 7, comprising deriving the signal under test be forming an exclusive OR of the signal at the signal line in the functional circuit (10) and a further signal at a further signal line (32) in the functional circuit (10).

10. A method according to claim 7, a number N of partly overlapping time intervals is used, shifted by integer multiples a clock period divided by the number N.
